# EUROPEAN PATENT APPLICATION

(11) **EP 4 648 586 A1**
(43) Date of publication of application: **12.11.2025**
(21) Application number: 23953614.7
(22) Date of filing: 28.09.2023
(51) Int. Cl.: H10K 59/12, H10K 59/122, H10K 50/19

(54) **DISPLAY PANEL AND DISPLAY APPARATUS**

(71) Applicant: Boe Technology Group Co., Ltd., Beijing 100015 (CN); Yunnan Invensight Optoelectronics Technology Co., Ltd., Kunming, Yunnan 650211 (CN); Beijing BOE Technology Development Co., Ltd., Daxing District Beijing 100176 (CN)
(72) Inventor: YANG, Zongshun, Beijing 100176 (CN); ZHANG, Dacheng, Beijing 100176 (CN); WANG, Zhiqiang, Beijing 100176 (CN); TAN, Bin, Beijing 100176 (CN); ZHANG, Fugang, Beijing 100176 (CN); HE, Baimei, Beijing 100176 (CN); YANG, Chao, Beijing 100176 (CN); HE, Yonghong, Beijing 100176 (CN)
(74) Representative: Potter Clarkson
(86) International application number: PCT/CN2023/122394
(87) International publication number: WO 2025/065463

(57) **Abstract**

A display panel and a display apparatus comprising the display panel. The display panel comprises a pixel definition portion. A recessed region (2105) is formed between two adjacent pixel electrodes (221) on the surface of the pixel definition portion away from a drive backplane (1). A bottom surface of the recessed region (2105) comprises a first smooth curved section protruding in a direction away from the drive backplane (1). The bottom surface of the recessed region (2105) is provided with a partition recess (2102). A common electrode (222) forms a protruding portion (2221) in an orthographic projection region of the partition recess (2102). The protruding first smooth curved section can enable the contour of the protruding portion (2221) to become curved, and increases the distance between the protruding portion (2221) and the pixel electrodes (221), such that the probability that the protruding portion (2221) punctures and contacts the pixel electrodes (221) is greatly reduced, thereby reducing the risk of short circuits between the common electrode and the pixel electrodes while ensuring the partitioning of a light-emitting layer group.

## Description

### TECHNICAL FIELD

The present disclosure relates to the field of display technology, and in particular to a display panel and a display apparatus.

### BACKGROUND

OLED (Organic Light Emitting Diode) display panels have been widely used in various display apparatuses. For display panels using stacked light-emitting devices, there are problems of crosstalk between sub-pixels of different colors.

In order to avoid problems of crosstalk as much as possible, a partition groove is set between two adjacent sub-pixels to partition the common layer. However, due to the existing partition groove, it easily results in the formation of an electric leakage path or electric field between the common electrode and the pixel electrode, causing cross-color between different sub-pixels, and affecting the color gamut and quality of the displayed image.

It should be noted that the information disclosed in the above background part is only used to enhance the understanding of the background of the present disclosure, and therefore may include information that does not constitute the related art known to those of ordinary skill in the art.

### SUMMARY

The objective of the present disclosure is to overcome the above-mentioned disadvantages of the related art and provide a display panel and a display apparatus.

According to an aspect of the present disclosure, there is provided a display pane including a driving backplane, a plurality of pixel electrodes, a pixel definition layer, a light-emitting layer group and a common electrode; the plurality of pixel electrodes are provided at intervals on a side of the driving backplane; the pixel definition layer is provided on a side of the plurality of pixel electrodes away from the driving backplane; the pixel definition layer is provided with pixel openings exposing the pixel electrodes; a pixel definition portion is provided between two adjacent pixel openings; a surface of the pixel definition portion away from the driving backplane is formed with a recessed region between two adjacent pixel electrodes; a bottom surface of the recessed region includes a first smooth curved surface raised towards a direction away from the driving backplane, and a partition groove is provided on the bottom surface of the recessed region; the light-emitting layer group is provided on a side of the pixel definition layer away from the driving backplane, and the light-emitting layer group is disconnected in the partition groove; the common electrode is provided on a side of the light-emitting layer group away from the driving backplane, and the common electrode is formed with a protruding portion going close to the driving backplane in an orthographic projection region of the partition groove; and a contour of the protruding portion is a curve.

In an embodiment of the present disclosure, the partition groove includes a first groove section and a second groove section sequentially away from the driving backplane, an orthographic projection of the second groove section on the driving backplane is located within an orthographic projection of the first groove section on the driving backplane, and an area of the orthographic projection of the second groove section on the driving backplane is smaller than an area of the orthographic projection of the first groove section on the driving backplane.

In an embodiment of the present disclosure, a side surface of the first groove section includes a second smooth curved surface that is recessed towards a direction close to the pixel openings.

In an embodiment of the present disclosure, a curvature of the second smooth curved surface is greater than a curvature of the first smooth curved surface.

In an embodiment of the present disclosure, a bottom surface of the first groove section includes a third smooth curved surface that is recessed towards a direction close to the driving backplane.

In an embodiment of the present disclosure, a curvature of the first smooth curved surface is greater than a curvature of the third smooth curved surface.

In an embodiment of the present disclosure, an angle between the bottom surface of the recessed region and a first direction is smaller than an angle between a side surface of the recessed region and the first direction, the angle between the side surface of the recessed region and the first direction is smaller than an angle between a side wall of a pixel opening and the first direction, and the first direction is perpendicular to a thickness direction of the display panel.

In an embodiment of the present disclosure, a pixel electrode includes a first pixel electrode layer and a second pixel electrode layer, the first pixel electrode layer is provided on a side of the driving backplane, the second pixel electrode layer includes a first covering portion, the first covering portion covers a surface of the first pixel electrode layer away from the driving backplane and covers a side surface of the first pixel electrode layer, and a material of the second pixel electrode layer is indium tin oxide.

In an embodiment of the present disclosure, the second pixel electrode layer further includes a second covering portion and a third covering portion, the second covering portion is connected to the first covering portion and extends towards a direction close to the driving backplane, the third covering portion is connected to the second covering portion, and the third covering portion is located between two adjacent first pixel electrode layers.

In an embodiment of the present disclosure, an angle between the first covering portion and the first direction is smaller than an angle between the second covering portion and the first direction.

In an embodiment of the present disclosure, the two adjacent pixel electrodes are defined as a first pixel electrode and a second pixel electrode respectively, a size of a third covering portion of the first pixel electrode in the first direction is d2, a size of a third covering portion of the second pixel electrode in the first direction is d2', a width of a portion of the recessed region that is located on a same side of the partition groove as the first pixel electrode is D1, a width of a portion of the recessed region that is located on a same side of the partition groove as the second pixel electrode is D1', and (d2-d2')×(D1-D1')>0.

In an embodiment of the present disclosure, a size of the first groove section in a second direction is greater than a size of the second covering portion in the second direction, and the second direction is a thickness direction of the display panel.

In an embodiment of the present disclosure, an orthographic projection of the protruding portion on the driving backplane does not overlap with an orthographic projection of the pixel electrode on the driving backplane.

In an embodiment of the present disclosure, an edge of the third covering portion is closer to an edge of the pixel opening than an edge of the first groove section in a first direction, and the first direction is perpendicular to a thickness direction of the display panel.

In an embodiment of the present disclosure, a pixel definition portion is provided between two adjacent pixel openings, the pixel definition portion includes a first sub-portion and a second sub-portion sequentially provided in the direction away from the driving backplane, the first groove section is a first through hole passing through the first sub-portion, and the second groove section is a second through hole passing through the second sub-portion.

In an embodiment of the present disclosure, the pixel definition portion further includes a third sub-portion, the third sub-portion fills a gap between the two adjacent pixel electrodes and partially covers the two pixel electrodes.

In an embodiment of the present disclosure, a width of the first groove section increases gradually in the direction away from the driving backplane.

In an embodiment of the present disclosure, a width of the second groove section decreases gradually in the direction away from the driving backplane.

In an embodiment of the present disclosure, an increase amplitude in the width of the first groove section increases gradually in the direction away from the driving backplane, and a decrease amplitude in the width of the second groove section decreases gradually in the direction away from the driving backplane.

In an embodiment of the present disclosure, the orthographic projection of the second groove section on the driving backplane overlaps with the orthographic projection of the first groove section on the driving backplane.

In an embodiment of the present disclosure, a width of the partition groove decreases gradually in the direction away from the driving backplane.

In an embodiment of the present disclosure, the light-emitting layer group includes a light-emitting layer sub-group, a common layer is provided between the light-emitting layer sub-group and the pixel electrodes, the common layer is disconnected between two adjacent partition grooves, and the light-emitting layer sub-group covers the common layer and a discontinuous position of the common layer.

In an embodiment of the present disclosure, the driving backplane includes a plurality of thin film transistors, and the thin film transistors are silicon-based thin film transistors.

According to another aspect of the present disclosure, there is provided a display apparatus, including the display panel provided in an aspect of the present disclosure.

It should be understood that the foregoing general description and the following detailed description are exemplary and explanatory only, and are not restrictions of the present disclosure.

### BRIEF DESCRIPTION OF THE DRAWINGS

The accompanying drawings, which are incorporated in and constitute a part of the description, illustrate embodiments consistent with the disclosure and together with the description serve to explain the principles of the disclosure. Obviously, the drawings in the following description are some embodiments of the present disclosure, and for those of ordinary skill in the art, other drawings can also be obtained from these drawings without creative efforts.
FIG. 1 is a schematic cross-sectional view of a display panel according to an embodiment of the present disclosure, in which the display panel includes a color film layer and a microlens layer.
FIG. 2 is a schematic cross-sectional view of a display panel according to an embodiment of the present disclosure, in which the pixel definition portion includes a first sub-portion and a second sub-portion, and the bottom surface of the recessed region is a plane.
FIG. 3 is a schematic cross-sectional view of a display panel according to an embodiment of the present disclosure, in which the pixel definition portion further includes a third sub-portion, and the bottom surface of the recessed region is a plane.
FIG. 4 is a schematic cross-sectional view of a display panel according to an embodiment of the present disclosure, in which the pixel definition portion includes a first sub-portion and a second sub-portion, and the bottom surface of the recessed region is a first smooth curved surface.
FIG. 5 is a schematic cross-sectional view of a display panel according to an embodiment of the present disclosure, in which the pixel definition portion further includes a third sub-portion, and the bottom surface of the recessed region is a first smooth curved surface.
FIG. 6 is a schematic cross-sectional view of a display panel according to an embodiment of the present disclosure, in which the pixel definition portion includes a first sub-portion and a second sub-portion, and the side surface of the first groove section is a second smooth curved surface.
FIG. 7 is a schematic cross-sectional view of a display panel according to an embodiment of the present disclosure, in which the pixel definition portion further includes a third sub-portion, and the side surface of the first groove section is a second smooth curved surface.
FIG. 8 is a partial enlarged view of the G portion in FIG. 7.
FIG. 9 is a diagram showing the sizes of various portions of the partition groove in the display panel shown in FIG. 7.
FIG. 10 is a partial enlarged view of the H portion in FIG. 9.
FIG. 11 is a cross-sectional schematic diagram of a display panel according to an embodiment of the present disclosure, in which the pixel definition portion further includes a third sub-portion, and the width of the first groove section gradually increases in a direction away from the driving backplane.
FIG. 12 is a cross-sectional schematic diagram of a display panel according to an embodiment of the present disclosure, in which the pixel definition portion further includes a third sub-portion, the width of the first groove section gradually increases in a direction away from the driving backplane, and the width of the second groove section gradually decreases in a direction away from the base substrate.
FIG. 13 is a schematic cross-sectional view of a display panel according to an embodiment of the present disclosure, in which the pixel definition portion further includes a third sub-portion, and the side wall of the partition groove is configured to be arc-shaped.
FIG. 14 is a cross-sectional schematic diagram of a display panel according to an embodiment of the present disclosure, in which the pixel definition portion further includes a third sub-portion, and the width of the first groove section and the width of the second groove section gradually decrease in a direction away from the driving backplane.
FIG. 15 is a cross-sectional schematic diagram of a display panel according to an embodiment of the present disclosure, in which the pixel definition portion further includes a third sub-portion, and the width of a side of the first groove section away from the base substrate is equal to the width of a side of the second groove section close to the base substrate.
FIG. 16 is a schematic cross-sectional view of a display panel according to an embodiment of the present disclosure, in which the pixel definition portion further includes a third sub-portion, and the width of the first groove section is equal to the width of the second groove section.
FIG. 17 is a cross-sectional schematic diagram of another display panel according to an embodiment of the present disclosure.

### Description of reference numerals:

1-driving backplane, 10-base substrate, 11-transistor, 111-gate, 112-active layer, 113-first source, 114-drain, 115-gate insulating layer, 116-second source, 12-first transistor, 13-second transistor, 14-contact hole, 15-insulating layer, 151-interlayer dielectric layer, 152-protecting layer, 153-planarization layer, 16-third conductive layer, 18-buffer layer, 100-driving circuit layer, 2-pixel layer, 21-pixel definition layer, 211-first sub-layer, 212-second sub-layer, 213-third sub-layer, 2101-pixel opening, 2102-partition groove, 2103-first groove section, 2104-second groove section, 2105-recessed region, 22-light-emitting device, 221-pixel electrode, 2211-first pixel electrode layer, 2212-second pixel electrode layer, 2213-first covering portion, 2214-second covering portion, 2215-third covering portion, 222-common electrode, 2221-protruding portion, 223-light-emitting layer group, 2231-light-emitting function layer, 2232-common layer, 2201-first light-emitting device, 2202-second light-emitting device, 2203-third light-emitting device, 3-color film layer, 31-black matrix, 32-filter sub-unit, 321-red filter sub-unit, 322-green filter sub-unit, 323-blue filter sub-unit, 33-encapsulation substrate, 4-encapsulation layer group, 41-first inorganic encapsulation layer, 42-organic encapsulation layer, 43-second inorganic encapsulation layer, 5-microlens layer, 51-microlens, 6-third planarization layer.

### DETAILED DESCRIPTION

Example embodiments will now be described more fully with reference to the accompanying drawings. Example embodiments, however, can be implemented in various forms and should not be construed as limited to the embodiments set forth herein; by contrast, these embodiments are provided so that the present disclosure will be thorough and complete, and will fully convey the concept of example embodiments to those skilled in the art. The same reference numerals in the drawings denote the same or similar structures, and thus their detailed descriptions will be omitted. In addition, the drawings are only schematic illustrations of the present disclosure and are not necessarily drawn to scale.

Although relative terms such as "upper" and "lower" are used in the description to describe the relative relationship between one component and another component, these terms are used in the description only for convenience, for example, according to the example orientations described in the drawings. It is understood that if the apparatus shown in the drawing is turned upside down, the component described as "upper" will become the component described as "lower". When a structure is "on" another structure, it may mean that the structure is formed integrally on another structure, or that the structure is "directly" provided on another structure, or that the structure is "indirectly" provided on another structure through still another structure.

The terms "a", "an", "the", "said" and "at least one" are used to indicate the presence of one or more elements/components/or the like; the terms "including" and "having" are used to express an open inclusive meaning and mean that additional elements/components/or the like may exist in addition to the listed elements/components/or the like; and the terms "first", "second" and "third" or the like are used merely as labels and are not intended to limit the quantity of their objects.

A micro organic light-emitting diode (Micro OLED) display panel is a micro organic light-emitting diode display panel in which a mono-silicon integrated circuit is used as a backplane and a top-emitting OLED device is used as a light source. The Micro OLED display panel has the advantages of small size, light weight, high contrast, fast response speed and low power consumption, which is expected to be used in the next generation of mobile display terminals. Currently, a white light-emitting layer (EL) plus a color filter (CF) layer is used in a micro OELD to achieve color display. The color filter (CF) layer absorbs lights of specific wavelengths, to allow monochromatic light, such as red light, blue light or green light, to pass through.

Since the micro OLED display panel has a relatively smaller size and an ultra-high pixel per inch (PPI), it is easy to cause cross-color between different sub-pixels, thus affecting the color purity and color gamut of the display panel. In severe cases, it will further cause electric leakage of the product at low grayscale, thus reducing the product quality. This type of display panel generally uses stacked light-emitting devices, in which two light-emitting function layers are connected through a common layer. The charge generation layer has a strong ability to transmit signals laterally, which is easy to cause lateral electric leakage, resulting in crosstalk between different sub-pixels.

While ensuring that the two adjacent light-emitting function layers are effectively connected through the common layer, the common layer needs to be partitioned laterally to avoid cross-color between different sub-pixels due to the existence of a lateral transmission path for carriers. When the common layer is partitioned, the region of the common electrode where the orthographic projection of the partition groove is located, is recessed downwards; and a protruding portion and a puncture going close to the driving backplane are formed. If there is a pixel electrode directly below the corresponding protruding portion and the puncture, it is easy to form an electric leakage path or electric field between the gaps of two adjacent pixel electrodes, and then light emitting occurs in the gaps between two adjacent pixel electrodes, causing cross-color in some regions between the sub-pixels, thus affecting the color gamut and quality of the displayed image.

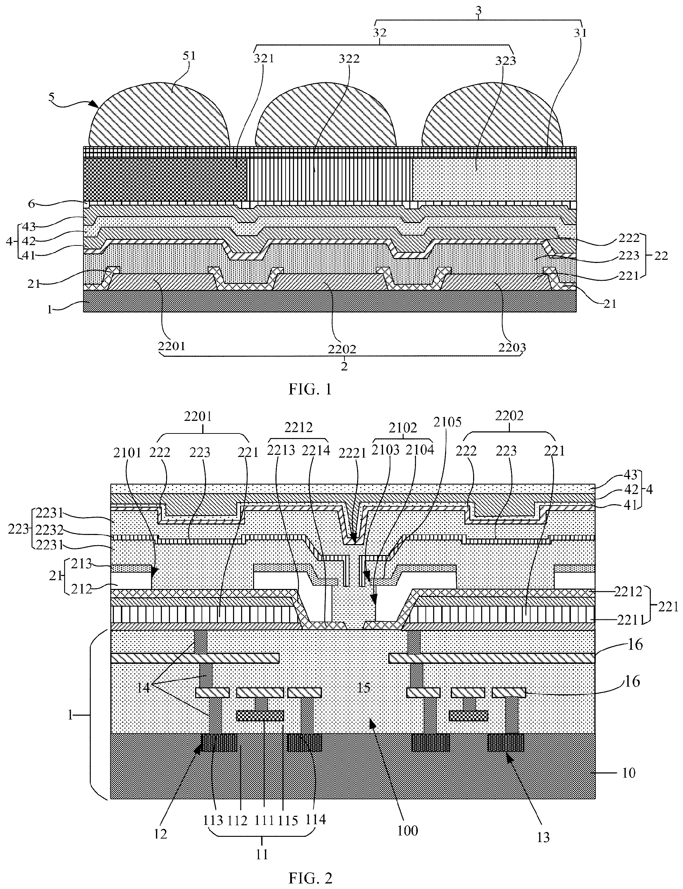

In view of this, the embodiments of the present disclosure provide a display panel, in which color crosstalk between different sub-pixels may be avoided. As shown in FIG. 1 and FIG. 4 to FIG. 17, the display panel includes a driving backplane 1, a plurality of pixel electrodes 221, a pixel definition layer 21, a light-emitting layer group 223 and a common electrode 222. The plurality of pixel electrodes 221 are provided at intervals on a side of the driving backplane 1; the pixel definition layer 21 is provided on the side of the plurality of pixel electrodes 221 away from the driving backplane 1, and the pixel definition layer 21 is provided with pixel openings 2101 exposing the pixel electrodes 221; a pixel definition portion is provided between two adjacent pixel openings 2101, and a surface of the pixel definition portion away from the driving backplane is formed with a recessed region 2105 between two adjacent pixel electrodes 221. The bottom surface of the region 2105 includes a first smooth curved surface protruding in a direction away from the driving backplane, and a partition groove is provided on the bottom surface of the recessed region 2105; the light-emitting layer group 223 is provided on the side of the pixel definition layer 21 away from the driving backplane 1, and the light-emitting layer group 223 is disconnected in the partition groove 2102; the common electrode 222 is provided on the side of the light-emitting layer group 223 away from the driving backplane 1, and the common electrode 222 is formed with a protruding portion 2221 close to the driving backplane in the orthographic projection region of the partition groove 2102; and the orthographic projection of the protruding portion 2221 on the driving backplane 1 does not overlap with the orthographic projection of the pixel electrode 221 on the driving backplane 1.

The surface of the pixel definition portion away from the driving backplane 1 is formed with a recessed region 2105 between two adjacent pixel electrodes 221. The bottom surface of the recessed region 2105 includes a first smooth curved surface raised toward the direction away from the driving backplane 1. A partition groove 2102 is provided on the bottom surface of the recessed region 2105. The common electrode 222 is formed with a protruding portion 2221 in the orthographic projection region of the partition groove 2102. The puncture position of the common electrode 222 is usually located within the protruding portion 2221. Due to the raised first smooth curved surface, the contour of the protruding portion 2221 forms a curve, and the distance between the protruding portion 2221 and the pixel electrode 221 is reduced, so that the probability that the puncture of the protruding portion 2221 is generated and the protruding portion 2221 is in contact with the pixel electrode 221 is greatly reduced, thus ensuring that the risk of short circuit between the common electrode and the pixel electrode is reduced while ensuring the partition of the light-emitting layer group.

The display panel according to the present disclosure is described in detail below in conjunction with specific embodiments.

As shown in FIG. 1 to FIG. 16, the display panel includes a pixel layer 2 and a color film layer 3. The light-emitting layer 2 may include a plurality of light-emitting devices 220. In FIG. 1, the plurality of light-emitting devices 220 are respectively a first light-emitting device 2201, a second light-emitting device 2202 and a third light-emitting device 2203. For example, the first light-emitting device 2201, the second light-emitting device 2202 and the third light-emitting device 2203 are respectively located in different sub-pixels, thus forming a pixel unit PX. The pixel unit PX, in combination with the color film layer 3, may emit full-color light. The color film layer 3 includes three filter sub-units of different colors, which are a red filter sub-unit 321, a green filter sub-unit 322 and a blue filter sub-unit 323 respectively.

As shown in FIG. 2 to FIG. 16, the light-emitting device 220 is a stacked electroluminescence device, which includes a pixel electrode 221, a common electrode 222 and a light-emitting layer group 223. The pixel electrode 221 may be an anode of the light-emitting device 220, and the common electrode 222 may be a cathode of the light-emitting device 220. The pixel electrodes 221 of different light-emitting devices 220 are disconnected and insulated from each other in a plane, and the pixel electrodes 221 of all light-emitting devices 220 form a first conductive layer. The common electrodes 222 of different light-emitting devices 220 are of an integrated structure, that is, the common electrodes 222 of different light-emitting devices 220 are of a continuous and smooth structure formed by the same conductive material layer, and the common electrodes 222 of all light-emitting devices 220 form a second conductive layer. There is no interface between different regions in the second conductive layer. The light-emitting layer group 223 is provided between the first conductive layer and the second conductive layer. The light-emitting layer group 223 includes two light-emitting function layers 2231, which are provided at intervals, and a common layer 2232 is provided between two adjacent light-emitting function layers 2231. The common layer 2232 is a charge generation layer, which is a connecting layer between the two light-emitting function layers 2231. The charge generation layer can separate electrons and holes, and transfer them to the two light-emitting function layers 2231 respectively.

One of the pixel electrode 221 and the common electrode 222 is a reflection electrode, and the other is a half transmission half reflection electrode. Whether the pixel electrode 221 is set as a transmission electrode or a half transmission electrode, or the common electrode 222 is set as a transmission electrode or a half transmission electrode, light is emitted from the transmission electrode or the half transmission electrode. It can be understood that one of the first conductive layer and the second conductive layer has reflectivity, and the other has the property of half transmission or transmission. For example, the pixel electrode 221 and the common electrode 222 in the first light-emitting device 2201 form a microcavity, so that the distance from each light-emitting function layer 2231 to the reflection layer and the wavelength of the light emitted by the light-emitting function layer 2231 satisfy 2Δ=mλ (m=1, 2, 3,...), where Δ is the optical path that which is equal to the refractive index of the medium multiplied by the distance of light propagation in the medium and multiplied by the refractive index of the medium, so that resonance is generated between the emitted light and the reflected light in the microcavity, thus improving the purity of the light emitting, and further improving the color gamut and light brightness of the display panel.

For example, the first conductive layer is a high work function material. For example, the first conductive layer also has high reflectivity. For example, the first conductive layer a stacked structure of Ti/Al/Ti/Mo, in which metal titanium may be used as a buffer layer to improve adhesion between layers, metal Al may be used as a material having high reflectivity, and metal Mo may be used as a high work function material that is in direct contact with the organic function layer to improve the injection capability of carriers.

For example, the material of the second conductive layer is a conductive material with low work function and high transmittance. For example, the material of the second conductive layer may be a transparent metal oxide conductive material, such as indium zinc oxide (IZO), indium tin oxide (ITO), indium gallium zinc oxide (IGZO), etc. The material of the second conductive layer may also be a transparent conductive nanomaterial such as carbon nanotubes, graphene, silver nanowires, etc.

The display panel further includes a driving backplane 1, which includes a base substrate 10 and a driving circuit layer 100. For the sake of clarity, only the first pixel sub-region and the second pixel sub-region adjacent in the pixel layer 2 are shown in FIG. 2 to FIG. 16. For each pixel sub-region, only the light-emitting element and the transistor 11 directly connected to the light-emitting element in the driving circuit layer 100 are shown. For example, the transistor 11 may be a driving transistor configured to control the magnitude of the current used for driving the light-emitting element to emit light. For example, the transistor 11 may also be a light-emitting control transistor for controlling the current used for driving the light-emitting element to emit light whether to pass through. The embodiments of the present disclosure are not limited to this.

As shown in FIG. 2 to FIG. 16, the driving backplane 1 includes a base substrate 10, a first conductive layer, an organic function layer, and a second conductive layer that are provided on the base substrate 10, where the organic function layer includes a carrier injection layer 229. The first conductive layer includes a pixel electrode 221 of the first light-emitting device 2201 and a pixel electrode 221 of the second light-emitting device 2202, which are insulated from each other and located in the first pixel sub-region and the second pixel sub-region, respectively. The pixel electrode 221 of the first light-emitting device 2201 and the pixel electrode 221 of the second light-emitting device 2202 are disconnected from each other. The second conductive layer includes a common electrode 222 of the first light-emitting device 2201 and a common electrode 222 of the second light-emitting device 2202, which are connected to each other and located in the first pixel sub-region and the second pixel sub-region, respectively.

In the display panel provided by the embodiments of the present disclosure, a silicon substrate is used as the base substrate 10, and a driving circuit layer 100 may be integrated on the silicon substrate to form the driving backplane 1. In this case, a higher precision may be achieved by using a silicon-based circuit. The first light-emitting element and the second light-emitting element are formed on the driving backplane 1, and the driving backplane 1 includes the base substrate 10 and the driving circuit layer 100 formed on the base substrate 10. The silicon substrate is, for example, single crystal silicon or high-purity silicon.

The driving circuit layer 100 is formed on the base substrate 10 by a semiconductor process. For example, an active layer 112 (i.e., a semiconductor layer), a first source 113, and a drain 114 of the transistor 11 are formed in the base substrate 10 by using a doping process, an insulating layer 15 is formed by using a silicon oxidation process, and a plurality of third conductive layers 16 are formed by using a sputtering process, etc. The semiconductor layer of the transistor 11 (such as the active layer in FIG. 2 to FIG. 14) is located inside the base substrate 10, or is a part of the base substrate 10.

The first light-emitting device 2201 is electrically connected to the first transistor 12, and the second light-emitting device 2202 is electrically connected to the second transistor 13. The specific types of the first transistor 12 and the second transistor 13 are not limited in the embodiments of the present disclosure. The first transistor 12 is exemplarily described below, and the description is also applicable to the second transistor 13, thus it will not be repeated.

The pixel electrode 221 of the first light-emitting element is formed on the surface of the driving backplane 1, and is electrically connected to the first source 113 of the first transistor 12 through the contact hole 14 filled with a conductive material (such as tungsten) and the more than one conductive layer. FIG. 2 to FIG. 16 exemplarily show one insulating layer 15 and two third conductive layers 16, but the number of insulating layer 15 and the number of conductive layer are not limited in the embodiments of the present disclosure.

For example, the first transistor 12 includes a gate 111, a gate insulating layer 115, an active layer 112, a first source 113 and a drain 114. The type, material, and structure of the first transistor 12 are not limited in the embodiments of the present disclosure. For example, the first transistor 12 may be a top gate transistor, a bottom gate transistor, etc. The active layer 112 of the first transistor 12 may be of an inorganic semiconductor material such as microcrystalline silicon, amorphous silicon, polycrystalline silicon (low temperature polycrystalline silicon or high temperature polycrystalline silicon), and an oxide semiconductor (such as IGZO); or the active layer 112 of the first transistor 12 may be of an organic material, for example an organic semiconductor material, such as PBTTT, PDBT-co-TT, PDQT, PDVT-10, dinaphtho-thieno thiophene (DNTT) or pentacene. For example, the first transistor 12 may be a N-type transistor or a P-type transistor.

It should be noted that the transistors used in the embodiments of the present disclosure may be thin film transistors, field effect transistors or other switching devices with the same characteristics. In some embodiments of the present disclosure, it is described by taking a field effect transistor (such as a MOS field effect transistor) formed in a silicon substrate as an example. In this example, an active layer of the transistor is formed by performing doping (p-type doping or n-type doping) on the silicon substrate; that is, the active layer of the transistor is located in the silicon substrate, or the active layer of the transistor is a part of the silicon substrate. The source and the drain of the transistor used here may be symmetrical in structure, so there may be no difference in structure between the source and the drain. In the embodiments of the present disclosure, in order to distinguish two electrodes of the transistor other than the gate, for example, one of the two electrodes may be directly described as the first source 113, and the other may be directly described as the drain 114.

In the embodiments of the present disclosure, it is described by taking a field effect transistor (such as a MOS field effect transistor) formed in a silicon substrate as an example. In this example, an active layer 112 of the transistor is formed by performing doping (p-type doping or n-type doping) on the silicon substrate; that is, the active layer 112 of the transistor is located in the silicon substrate, or the active layer 112 of the transistor is a part of the silicon substrate. The source and the drain of the transistor used here may be symmetrical in structure, so there may be no difference in structure between the source and the drain. In the embodiments of the present disclosure, in order to distinguish two electrodes of the transistor other than the gate, for example, one of the two electrodes may be directly described as the first source 113, and the other may be directly described as the drain 114.

The topmost conductive layer in the driving backplane 1 may have reflectivity, for example, is of a stacked structure of titanium/titanium nitride/aluminum. For example, the conductive layer includes a plurality of sub-layers provided at intervals, which are respectively provided in one-to-one correspondence with the plurality of pixel electrodes 221 included in the first conductive layer. In the top emission structure, the conductive layer may be set as a reflection layer to reflect the light emitted by the light-emitting element to improve the light extraction efficiency. For example, the orthographic projection of each electrode in the first conductive layer on the base substrate 10 is located within the orthographic projection of the portion of the conductive layer corresponding to the electrode on the base substrate 10. In this case, the first conductive layer may adopt a transparent conductive oxide material with a high work function, such as ITO, IZO, IGZO, AZO, etc.

The light-emitting layer 2 of the pixel layer 2 includes a first light-emitting device 2201 and a second light-emitting device 2202 located in the first pixel sub-region and the second pixel sub-region, respectively. Each of the first light-emitting device 2201 and the second light-emitting device 2202 includes a light-emitting layer group 223, a common electrode 222 and a pixel electrode 221 corresponding to the light-emitting layer group 223. For example, the first light-emitting device 2201 and the second light-emitting device 2202 may be organic light-emitting diodes (OLED) or quantum dot light-emitting diodes (QLED), etc., and the type of the light-emitting element is not limited in the embodiments of the present disclosure. For example, the light-emitting layer group 223 may be a small molecule organic material or a polymer organic material.

For example, the first light-emitting device 2201 and the second light-emitting device 2202 have top emission structures; and the pixel electrode 221 and the common electrode 222 have reflectivity. For example, the pixel electrode 221 includes a first pixel electrode layer 2211. A material with high work function and high reflectivity may be used as the first pixel electrode layer 2211. For example, the first pixel electrode layer 2211 has a stacked structure of Ti/Al/Ti/Mo, in which metal titanium may be used as a buffer layer to improve the adhesion between layers, metal Al may be used as a material having high reflectivity, and metal Mo may be used as a high work function material that is in direct contact with the organic function layer to improve the injection capacity of carriers. Correspondingly, the second conductive layer is used as a cathode; for example, the second conductive layer may be of a transparent conductive material, or has a stacked structure of a transparent conductive material and a metal material. For example, the second conductive layer may be of a transparent metal oxide conductive material, such as indium zinc oxide (IZO), indium tin oxide (ITO), indium gallium zinc oxide (IGZO), etc. The second conductive layer may also be of a transparent conductive nanomaterial, such as carbon nanotubes, graphene, silver nanowires, etc.

In order to better ensure the setting accuracy of the sub-pixels, a pixel definition layer 21 is provided on the side of the pixel electrode 221 away from the base substrate 10. The pixel definition layer 21 is provided with a pixel opening 2101 exposing the pixel electrode. The position and size of each sub-pixel are defined by setting the pixel opening 2101 to better control the accuracy of each sub-pixel. The pixel definition layer 21 includes a first sub-layer 211, a second sub-layer 212, and a third sub-layer 213 that are sequentially provided in a direction away from the base substrate 10. The materials of the second sub-layer 212 and the third sub-layer 213 may be silicon oxide, and the material of the first sub-layer 211 may be silicon nitride.

Different light-emitting devices 220 are controlled to emit light by the driving circuit layer 100, so that the pixel layer 2 may realize the function of image display. Specifically, the source may be connected to the pixel electrode 221 of the light-emitting device 220, and the light-emitting device 220 may be driven to emit light by applying a signal to the pixel electrode 221. The specific light-emitting principle will not be described in detail here. At least part of the light-emitting device 220 may adopt any of the above-mentioned stacked electroluminescent devices, and its structure and material have been described in detail, which will not be repeated.

As shown in FIG. 2, the pixel definition portion is provided between two adjacent pixel openings 2101. The surface of the pixel definition portion away from the base substrate is formed with a recessed region 2105 between two adjacent pixel electrodes 221. In order to avoid crosstalk between different sub-pixels due to the common layer 2232, a partition groove 2102 is provided on the bottom surface of the recessed region 2105. Since the light-emitting layer group 223 is provided on the side of the pixel definition layer 21 away from the base substrate 10, the light-emitting layer group 223 may be formed with a recessed portion in the partition groove 2102, and the common layer 2232 is partitioned in the recessed portion. The pixel definition portion includes a first sub-portion located in the first sub-layer 211, a second sub-portion located in the second sub-layer 212, and a third sub-portion located in the third sub-layer 213.

The partition groove 2102 includes a first groove section 2103 and a second groove section 2104 that are sequentially away from the driving backplane 1. The first groove section 2103 is a first through hole passing through the first sub-portion, and the second groove section 2104 is a second through hole passing through the second sub-portion. The orthographic projection of the second groove section 2104 on the driving backplane 1 is located within the orthographic projection of the first groove section 2103 on the driving backplane 1, and the area of the orthographic projection of the second groove section 2104 on the driving backplane 1 is smaller than the area of the orthographic projection of the first groove section 2103 on the driving backplane 1. It may be understood that the longitudinal section of the partition groove 2102 is of an inverted T shape.

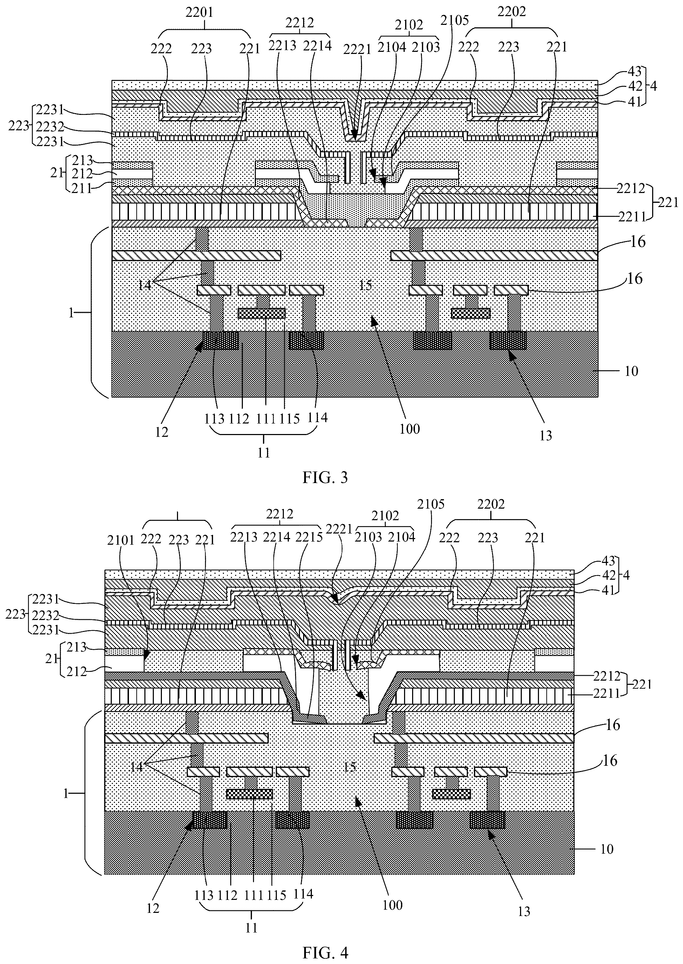

In order to further improve the effect of avoiding that an electric field is formed due to electric leakage, the pixel electrode 221 may be insulated. Specifically, the first sub-portion is provided to extend to cover the side of the second pixel electrode layer 2212. As shown in FIG3, in order to improve the insulation effect on the pixel electrode 221, the pixel definition portion may further include a third sub-portion, which fills the gap between two adjacent second pixel electrode layers 2212 and partially covers the two second pixel electrode layers 2212.

The common electrode 222 is provided on a side of the light-emitting layer group 223 away from the driving backplane 1; and the common electrode 222, in the orthographic projection region of the partition groove 2102, is formed with a protruding portion 2221 going close to the base substrate 10. In FIG. 2 and FIG. 3, the contour of the protruding portion 2221 is composed of fold lines, it is easy to form a spike on the protruding portion 2221, the distance between the bottom of the protruding portion 2221 and the second pixel electrode layer 2212 is relatively smaller, and the common electrode 222 is easy to puncture the light-emitting layer group 223 and be in contact with the pixel electrode 221.

In order to enhance the corrosion resistance of the pixel electrode 221, the pixel electrode 221 further includes a second pixel electrode layer 2212, and the material of the second pixel electrode layer 2212 is indium tin oxide (ITO). The second pixel electrode layer 2212 is provided on the side of the first pixel electrode layer 2211 away from the base substrate 10. The second pixel electrode layer 2212 covers the surface of the first pixel electrode layer 2211 away from the driving backplane 1, and covers the side surface of the first pixel electrode layer 2211. The orthographic projection of the protruding portion 2221 on the driving backplane 1 overlaps with the orthographic projection of the second pixel electrode layer 2212 of the pixel electrode 221 on the driving backplane 1, and it is easy to form an electric leakage path or electric field between the gaps of two adjacent pixel electrodes 221.

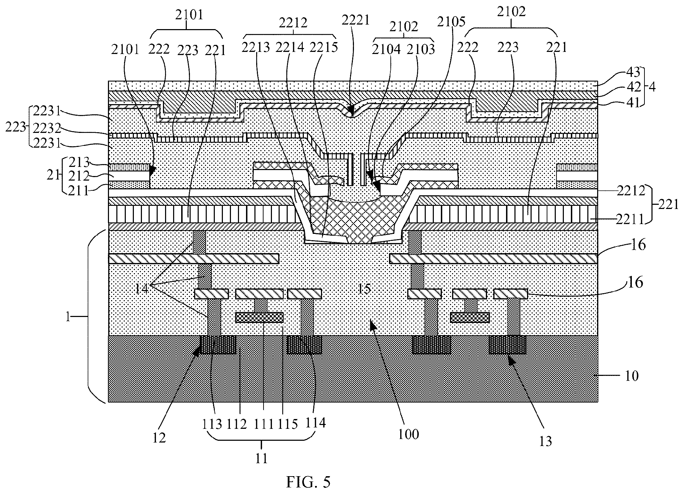

As shown in FIG. 4 and FIG. 5, in order to prevent the common electrode 222 from piercing the light-emitting layer group 223, the bottom surface of the recessed region 2105 is provided as a first smooth curved surface that is raised towards a direction away from the base substrate, so that part of the light-emitting layer group 223 flows into the periphery of the recessed region 2105, and the light-emitting layer group 223 flowing into the middle of the recessed region 2105 becomes less. The contour of the protruding portion 2221 forms a curve, and the distance between the protruding portion 2221 and the second pixel electrode layer 2212 is reduced, so that the probability that the puncture of the protruding portion 2221 is generated and the protruding portion 2221 is in contact with the pixel electrode 221 is greatly reduced, thus ensuring that the risk of a short circuit between the anode and cathode due to cathode puncture is reduced while partitioning the organic light-emitting layer.

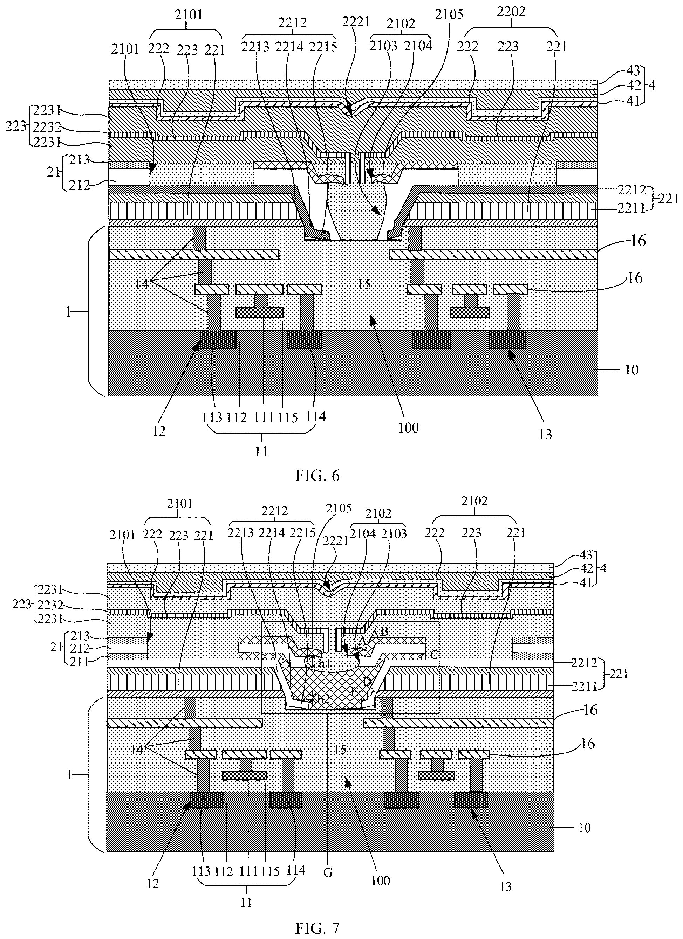

As shown in FIG. 6 and FIG. 7, the side surface of the first groove section 2103 is a second smooth curved surface that is recessed towards the direction close to the pixel opening 2101, which may reduce failure of the light-emitting device due to the static electricity generated during the display panel manufacturing process. The curvature of the second smooth curved surface is greater than the curvature of the first smooth curved surface. It can be understood that the curvature of the first smooth curved surface being relatively smaller, means that the first smooth curved surface is smoother than the second smooth curved surface. Therefore, while ensuring effective partition of the common layer, the structure of the partition groove 2102 causes the curve profile of the protruding portion 2221 relatively smoother, which may reduce the possibility of forming a spike on the protruding portion 2221, thus reducing the probability that the common electrode 222 pierces the light-emitting layer group 223 and is in contact with the pixel electrode 221.

The bottom surface of the first groove section 2103 is a third smooth curved surface that is recessed towards a direction close to the base substrate, and the curvature of the first smooth curved surface is greater than the curvature of the third smooth curved surface. The third smooth curved surface is smoother than the first smooth curved surface, so that the curvature of the bottom of the curved profile of the protruding portion 2221 is smaller than the curvature of the side of the curved profile of the protruding portion 2221, which may further reduce the possibility of forming a spike on the protruding portion 2221. It should be noted that the bottom surface of the first groove section 2103 is the surface of the first sub-layer 211 away from the base substrate within the partition groove 2102.

The angle between the bottom surface of the recessed region 2105 and a first direction is a fourth slope angle D, the angle between the side surface of the recessed region 2105 and the first direction is a fifth slope angle E, and the fourth slope angle D is less than the fifth slope angle E. The angle between the side wall of the pixel opening 2101 and the first direction is a sixth slope angle F, the sixth slope angle F is less than the fifth slope angle E, and the first direction is perpendicular to the thickness direction of the display panel. It can be understood that from the pixel opening 2101 to the partition groove 2102, the slope angles of each surface of the pixel definition portion gradually decrease, so that the combination of the light-emitting layer group 223 and the pixel definition layer 21 becomes gradually tighter. When the light-emitting layer group 223 is subjected to a tension from the partition groove 2102, it is not easy for the light-emitting layer group 223 to peel off from the pixel definition layer 21, which is more conducive to the common layer being partitioned in the partition groove 2102.

The second pixel electrode layer 2212 includes a first covering portion 2213, which covers a surface of the first pixel electrode layer 2211 away from the driving backplane 1 and covers the side surface of the first pixel electrode layer 2211. When the partition groove 2102 is set, the driving backplane 1 may generally be over-etched to a certain extent, so that an etching groove is formed on the surface of the driving backplane 1. Therefore, the second pixel electrode layer 2212 may further include a second covering portion 2214 and a third covering portion 2215. The second covering portion 2214 is connected to the first covering portion, and extends along the side surface of the etching groove. The second covering portion 2214 at least covers part of the side surface of the etching groove. The third covering portion 2215 is connected to the second covering portion 2214, and the third covering portion 2215 extends to the region between two first pixel electrode layers 2211.

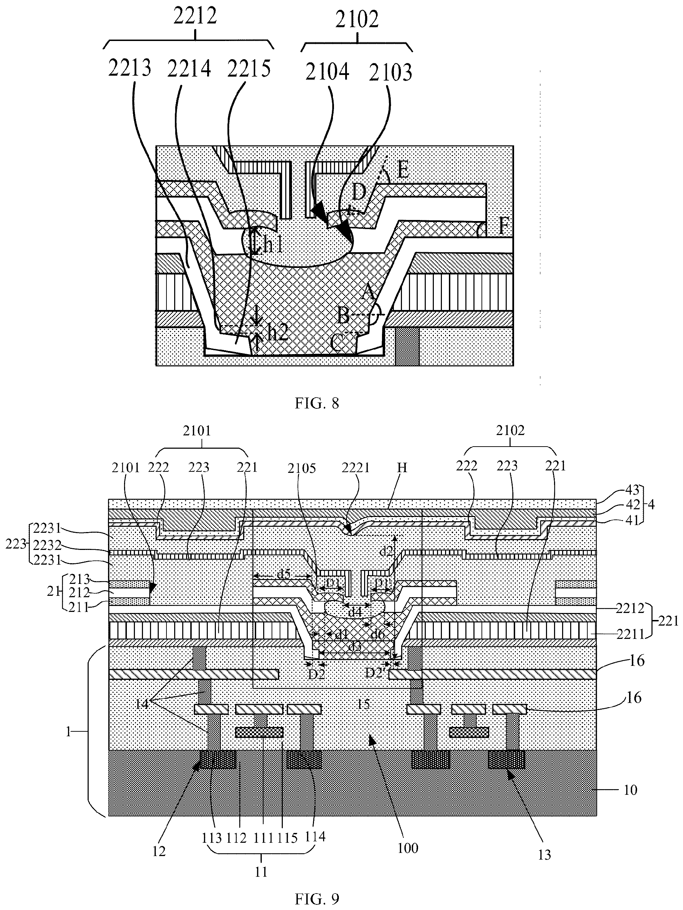

As shown in FIG. 7 and FIG. 8, the angle between the first direction and the portion of the first covering portion in contact with the side surface of the first pixel electrode layer is a first slope angle, the angle between the second covering portion 2214 and the first direction is a second slope angle, and the first slope angle is smaller than the second slope angle. The second covering portion 2214 may fully cover the side surface of the first pixel electrode layer; however, the second covering portion 2214 is actually a structure that is not desired to be conductive; therefore, the second slope angle is greater, which may reduce the probability of being in contact with the protruding portion 2221, and reduce the risk of crosstalk between light-emitting devices. The third slope angle is greater than 0, so that the third covering portion 2215 is inclined towards the side close to the base substrate, thus the distance between the protruding portion 2221 and the second pixel electrode layer 2212 may be increased, and further reducing the risk of crosstalk.

During the formation of the pixel electrode 221, there is usually a case that the lengths of the third covering portions 2215 of two adjacent second pixel electrode layers 2212 are unequal to each other. The two adjacent pixel electrodes 221 are defined as the first pixel electrode and the second pixel electrode, respectively. The size of the third covering portion 2215 of the first pixel electrode in the first direction is D2, the size of the third covering portion 2215 of the second pixel electrode in the first direction is D2', the width of the portion of the recessed region 2105 located on the same side of the partition groove 2102 as the first pixel electrode is D1, and the width of the portion of the recessed region 2105 located on the same side of the partition groove 2102 as the second pixel electrode is D1', where (D2-D2') × (D1-D1')>0.

It can be understood that the third covering portion 2215 is actually a structure that is not desired to be conductive. The greater the size of the third covering portion 2215 in the first direction, the greater the width of the portion of the recessed region 2105 located on the same side of the partition groove 2102 as the third covering portion 2215, thus reducing the probability of forming an electric leakage path or electric field between the edge of the third covering portion 2215 and the protruding portion 2221 of the common electrode 222, reducing crosstalk between different light-emitting devices, and further reducing the generation of stray light on the display panel.

The size of the first groove section 2103 in a second direction is greater than the size of the second covering portion 2214 in the second direction. It can be understood that when the size of the first groove section 2103 is relatively greater, more light-emitting layer groups 223 may enter the partition groove 2102, and a greater tension may be applied to the common layer, so that the partition groove 2102 has a better partition effect. The second direction is the thickness direction of the display panel.

As shown in FIG. 9, the orthographic projection of the protruding portion 2221 on the driving backplane 1 does not overlap with the orthographic projection of the second pixel electrode layer 2212 of the pixel electrode 221 on the driving backplane 1, which may be avoided that an electric leakage path or electric field in the protruding portion 2221 is formed within the partition groove 2102 between adjacent pixel openings 2101. The orthographic projection of the protruding portion 2221 on the base substrate 10 is usually located within the orthographic projection of the second groove section 2104 on the base substrate 10. Therefore, the third covering portion 2215 may be provided as closer to the edge of the pixel opening 2101 relative to the second groove section 2104; that is, the orthographic projection of the edge of the third covering portion 2215 on the base substrate 10 is located between the orthographic projection of the first groove section 2103 on the base substrate 10 and the orthographic projection of the second groove section 2104 on the base substrate 10. In this way, it may avoid that the protruding portion 2221 is formed with an electric leakage path or electric field within the partition groove 2102 between adjacent pixel openings 2101.

In order to improve the effect of preventing from electric leakage and forming an electric field, the third covering portion 2215 may be provided as closer to the edge of the pixel opening 2101 relative to the first groove section 2103 in the first direction. That is, the orthographic projection of the third covering portion 2215 on the base substrate 10 and the orthographic projection of the edge of the partition groove 2102 on the base substrate 10 are located between the orthographic projection of the edge of the pixel opening 2101 on the base substrate 10 and the orthographic projection of the first groove section 2103 on the base substrate 10. In this way, it may be better avoided that the protruding portion 2221 is formed with an electric leakage path or electric field within the partition groove 2102 between adjacent pixel openings 2101. It should be noted that the first direction is perpendicular to the thickness direction of the display panel.

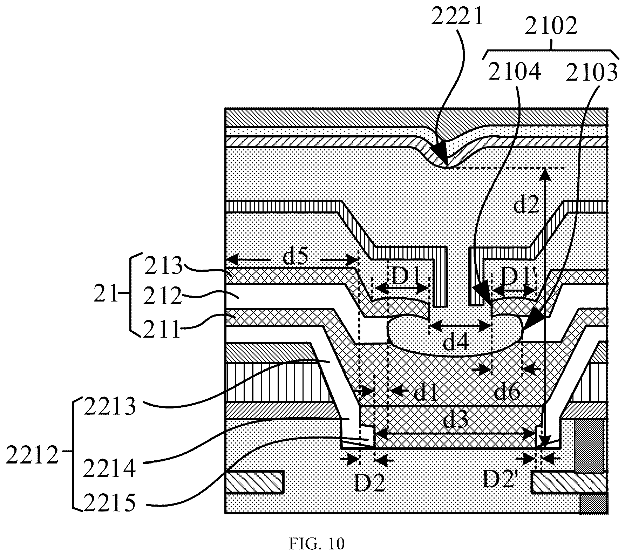

As shown in FIG. 9 and FIG. 10, the distance between an end of the third covering portion 2215 away from the first covering portion 2213 and the first groove section 2103 in the first direction is d1, where 0.05µm≤d1≤0.2µm, so as to better control the safety distance between the edge of the second pixel electrode layer 2212 and the edge of the first groove section 2103. In an implementable embodiment, it may be set as 0.05µm≤d1≤0.07.

The distance between an end of the side surface of the first covering portion 2213 close to the driving backplane 1 and the side surface of the pixel definition portion is d5, and the ratio of d5 to d1 is greater than or equal to 1 and less than or equal to 8, that is, 0.05µm≤d5≤1.6µm, so that the value for covering the edge of the second pixel electrode layer 2212 is relatively greater, which is conducive to preventing from electric leakage of the edge of the pixel electrode 221, while taking the size of the pixel opening 2101 into account to ensure a reasonable pixel opening ratio. In an implementable embodiment, it may be set as 0.2µm≤d5≤0.4µm.

The maximum width of the second groove section 2104 is d4, and the ratio of d4 to d1 is greater than or equal to 2 and less than or equal to 9, that is, 0.1µm≤d5≤1.8µm. While ensuring the effect of partitioning the common layer 2232, the width of the second groove section 2104 is minimized as much as possible, so that the protruding portion 2221 formed on the common electrode 222 becomes narrower, and the amount of the light-emitting layer group 223 entering the second groove section 2104 may also be reduced. Therefore, the recessed portion formed on the side of the light-emitting layer group 223 away from the base substrate 10 becomes shallower, and the height of the protruding portion 2221 is reduced. The distance between the protruding portion 2221 and the second pixel electrode layer 2212 is increased, and the possibility of forming an electric field and generating electric leakage between the common electrode 222 and the second pixel electrode layer 2212 in the partition groove 2102 is reduced. In an implementable embodiment, it may be set as 0.4µm≤d4≤0.45µm.

The distance between the third covering portions 2215 of two adjacent second pixel electrode layers 2212 is d3, and the ratio of d3 to d1 is greater than or equal to 3.5 and less than or equal to 20, that is, 0.175µm≤d3≤4µm, so as to ensure that the orthographic projection of the protruding portion 2221 on the driving backplane 1 does not overlap with the orthographic projection of the pixel electrode 221 on the driving backplane 1. In an implementable embodiment, d3-2d1-d4>0.1µm.

The ratio of the width D2 of the third covering portion 2215 to dl is greater than or equal to 1 and less than or equal to 4, that is, 0.05µm≤D2≤0.8µm. The second pixel electrode layer 2212 may completely cover the first pixel electrode layer 2211 to prevent from corrosion of the first pixel electrode layer 2211. In an implementable embodiment, it may be set as 0.07µm≤D2≤0.12µm.

The distance between the edge of the second groove section 2104 and the edge of the first groove section 2103 is d6, and the ratio of d6 to d1 is greater than or equal to 0.5 and less than or equal to 2.5, that is, 0.025µm≤d6≤0.5µm, so as to effectively partition the common layer 2232. In an implementable embodiment, it may be set as d6≥0.05µm.

The distance between the protruding portion 2221 and two adjacent pixel electrodes 221 in the second direction is d2, the ratio of d2 to d1 is greater than or equal to 5 and less than or equal to 70, that is, 0.25µm≤d2≤14µm, and the second direction is the thickness direction of the display panel. In an implementable embodiment, it may be set as 1.0µm≤d2≤3.5µm.

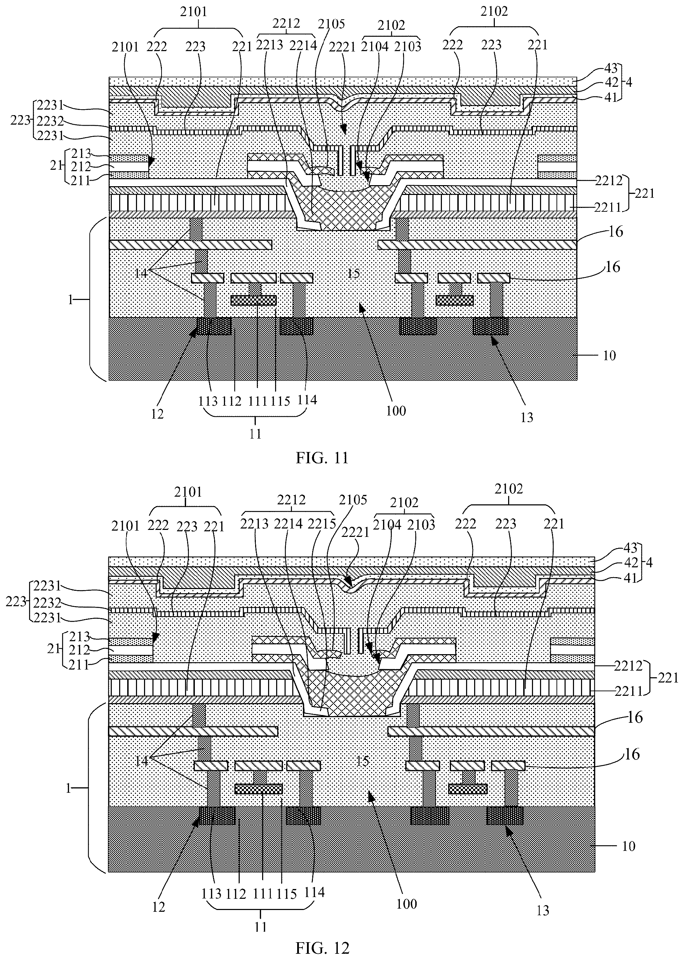

As shown in FIG. 11, it may be further set as that the width of the first groove section 2103 is gradually increased in the direction away from the driving backplane 1. Without affecting the partitioning effect of the partition groove 2102, the amount of the light-emitting layer group 223 entering the partition groove 2102 may be further reduced, so that the recessed portion formed on the side of the light-emitting layer group 223 away from the base substrate 10 becomes shallower. Therefore, the height of the protruding portion 2221 formed by the common electrode 222 is reduced, the distance between the protruding portion 2221 and the second pixel electrode layer 2212 is increased, thus reducing the possibility of forming an electric field and generating electric leakage between the common electrode 222 and the second pixel electrode layer 2212 in the partition groove 2102.

As shown in FIG. 12, based on FIG. 11, it may be set as that the width of the second groove section 2104 is gradually decreased in the direction away from the base substrate 10, so that the second groove section 2104 itself may form a partition structure to partition the common layer 2232. In addition, the thickness of the third sub-portion is usually smaller than the thickness of the second sub-portion. Therefore, the amount of the light-emitting layer group 223 entering the partition groove 2102 may also be reduced due to the partition groove 2102 of this structure, while improving the partition effect.

It should be noted that the first direction is the x direction in the drawings, and the second direction is the y direction in the drawings.

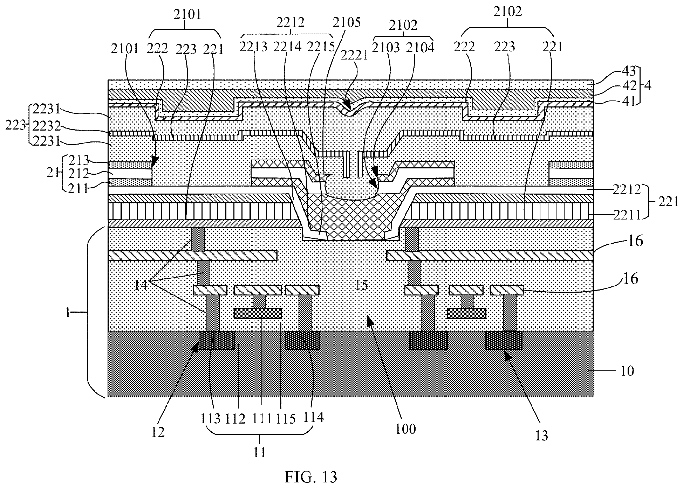

As shown in FIG. 13, based on FIG. 12, the side wall of the partition groove 2102 may be set as an arc shape, the increase amplitude in the width of the first groove section 2103 gradually increases in the direction away from the base substrate 10, and the decrease amplitude in the width of the second groove section 2104 gradually decreases in the direction away from the base substrate 10, which may further enhance the partition effect of the partition groove 2102.

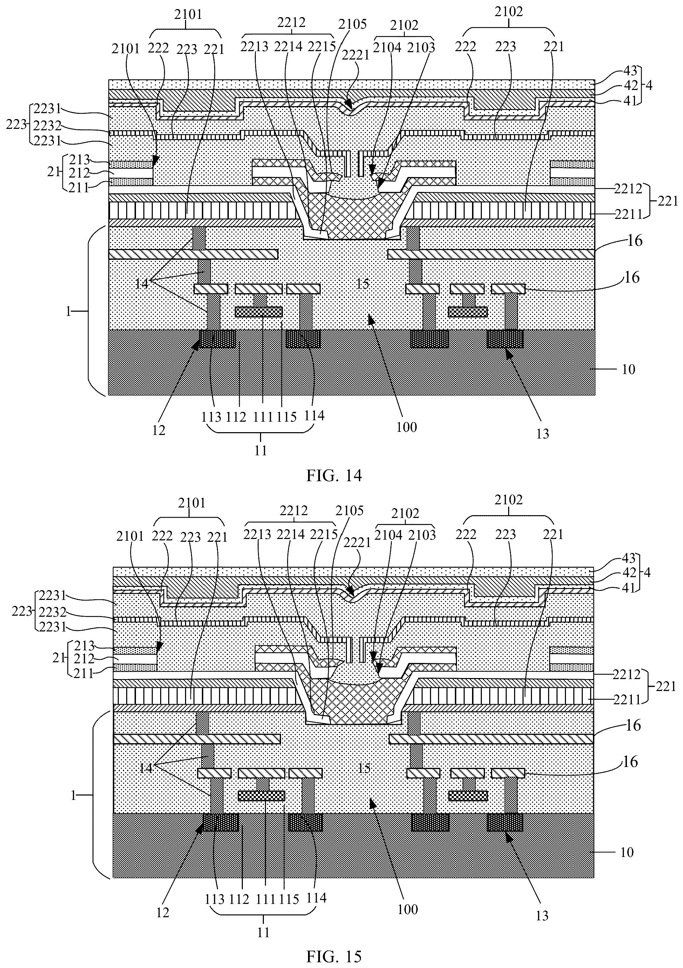

As shown in FIG. 14, it may be set as that the width of the first groove section 2103 and the width of the second groove section 2104 decrease gradually in the direction away from the driving backplane 1. In this way, the first groove section 2103 and the second groove section 2104 may form a partition structure respectively. Therefore, the partition groove 2102 in FIG. 10 may be formed as two partition structures, which may enhance the partition effect of the partition groove 2102.

As shown in FIG. 15, in other embodiments, it may be set as that the width of the first groove section 2103 on the side away from the base substrate 10 is equal to the width of the second groove section 2104 on the side close to the base substrate 10. That is, the width of the partition groove 2102 decreases gradually in the direction away from the driving backplane 1. The partition groove 2102 may be formed by using a single etching process, and the process cost may be saved.

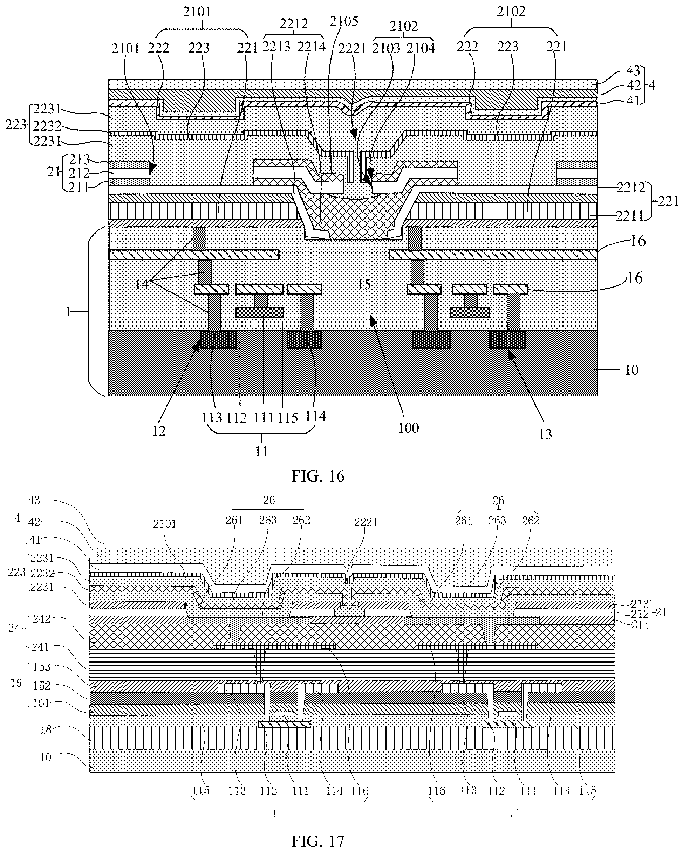

As shown in FIG. 16, it may be set as that the orthographic projection of the second groove section 2104 on the driving backplane 1 overlaps with the orthographic projection of the first groove section 2103 on the driving backplane 1. That is, the width of the first groove section 2103 is reduced, so that the width of the first groove section 2103 is equal to the width of the second groove section 2104. In other words, d6 is reduced to 0. In this way, the common layer 2232 may also be partitioned, and the amount of the light-emitting layer group 223 entering the partition groove 2102 may be reduced, so that the recessed portion formed on the side of the light-emitting layer group 223 away from the base substrate 10 becomes shallower, thus further reducing the height of the protruding portion 2221 formed by the common electrode 222.

Referring to FIG. 1, an encapsulation layer group 4 is provided on the side of the pixel layer 2 away from the base substrate 10, so as to cover the pixel layer 2 to prevent from water and oxygen corrosion. The encapsulation layer group 4 may be of a single-layer or multi-layer structure, and the material of the encapsulation layer group 4 may include organic or inorganic materials, which are not particularly limited here.

In the embodiment, the encapsulation layer group 4 may include a first inorganic encapsulation layer 41, an organic encapsulation layer 42 and a second inorganic encapsulation layer 43. The first inorganic encapsulation layer 41 is provided on the side of the pixel layer 2 away from the base substrate 10, the organic encapsulation layer 42 is provided on the side of the first inorganic encapsulation layer 41 away from the base substrate 10, and the second inorganic encapsulation layer 43 is provided on the side of the organic encapsulation layer 42 away from the base substrate 10.

A color film layer 3 may be provided on a side of the encapsulation layer group 4 away from the driving backplane 1. The color film layer 3 includes an encapsulation substrate 33. A black matrix 31 is provided on a side of the encapsulation substrate 33. An opening region array is defined by the black matrix 31. The opening region array includes a plurality of opening region rows arranged along the row direction. Each opening region row includes a plurality of opening regions. A filter sub-unit is provided in each opening region. Two adjacent filter sub-units in the opening region row have different colors. A plurality of filter sub-units located in the same opening region row constitute a plurality of filter units 32. Typically, a filter unit 32 may include a red filter sub-unit 321, a green filter sub-unit 322, and a blue filter sub-unit 323.

A third planarization layer may be provided between the second inorganic encapsulation layer 43 and the layer where the plurality of filter units are located, so that the color film layer 3 located on the third planarization layer is relatively flatter, thus ensuring the position of each filter sub-unit and further ensuring the pixel accuracy of the display panel.

FIG. 17 shows another display panel, in which an active matrix organic light-emitting diode (AMOLED) is used. The driving circuit layer 100 of the display panel is provided on the base substrate 10, and the pixel layer 2 is provided on the side of the driving circuit layer 100 away from the base substrate 10. The driving circuit layer 100 includes a thin film transistor, and a buffer layer 18 may also be provided between the driving circuit layer 100 and the base substrate 10.

In a case that the transistor 11 is a thin film transistor, the base substrate 10 may be a substrate made of an inorganic material or an organic material. For example, in an embodiment of the present disclosure, the base substrate 10 may be made of a glass material such as soda-lime glass, quartz glass, sapphire glass, etc., or be made of a metal material such as stainless steel, aluminum, nickel, etc.

In another embodiment of the present disclosure, the material of the base substrate 10 may be polymethyl methacrylate (PMMA), polyvinyl alcohol (PVA), polyvinyl phenol (PVP), polyether sulfone (PES), polyimide, polyamide, polyacetal, poly carbonate (PC), polyethylene terephthalate (PET), polyethylene naphthalate (PEN), or a combination of them.

In another embodiment of the present disclosure, the base substrate 10 may also be a flexible substrate. For example, the material of the base substrate 10 may be polyimide (PI). The base substrate 10 may also be a composite of multiple layers of materials. For example, in an embodiment of the present disclosure, the base substrate 10 may include a bottom film layer, a pressure-sensitive adhesive layer, a first polyimide layer, and a second polyimide layer that are stacked in sequence.

The thin film transistor may be selected from a top-gate thin film transistor, a bottom-gate thin film transistor or a dual-gate thin film transistor. The top-gate thin film transistor is taken as an example for description.

The thin film transistor may include an active layer 112, a gate insulating layer 115, a gate 111, a source and a drain, where:

The active layer 112 is provided on a side of the base substrate 10, and the material of the active layer 112 may be polycrystalline silicon, amorphous silicon, etc. The active layer 112 may include a channel region, a source region and a drain region; and the source region and the drain region are of different doping types and located on either side of the channel region. Among them, the channel region may maintain semiconductor properties, and the semiconductor materials in the source region and the drain region may be partially or completely caused to be conductive.

The gate insulating layer 115 may cover the active layer 112 and the base substrate 10, and the material of the gate insulating layer 115 is an insulating material such as silicon oxide. The gate 111 is provided on the side of the gate insulating layer 115 away from the base substrate 10, and is directly opposite to the active layer 112; that is, the projection of the gate 111 on the base substrate 10 is located within the range of the projection of the active layer 112 on the base substrate 10. For example, the projection of the gate 111 on the base substrate 10 coincides with the projection of the channel region of the active layer 112 on the base substrate 10.

In a case that the transistor 11 is a thin film transistor, the insulating layer 15 includes an interlayer dielectric layer 151 provided on a side of the gate 111 away from the base substrate 10. The interlayer dielectric layer 151 covers the gate 111 and the gate insulating layer 115, and the interlayer dielectric layer 151 is of an insulating material. The source and the drain are provided on a surface of the interlayer dielectric layer 151 away from the base substrate 10, and the source and the drain are connected to the active layer 112. For example, the source and the drain are respectively connected to the corresponding source region and the drain region of the active layer 112 through via holes.

The insulating layer 15 further includes a protecting layer 152, which is provided on the side of the source and the drain away from the base substrate 10. The protecting layer 152 covers the source and the drain. The insulating layer 15 further includes a planarization layer 153, which is provided on the side of the source and the drain away from the base substrate 10. The planarization layer 153 is provided on the side of the protecting layer 152 away from the base substrate 10, and the planarization layer 153 covers the protecting layer 152. The surface of the planarization layer 153 away from the base substrate 10 is a plane.

A pixel layer 2 is provided on the side of the insulating layer 15 away from the base substrate, and an encapsulation layer group 4 is provided on the side of the pixel layer 2 away from the base substrate 10, so as to cover the pixel layer 2 to prevent from water and oxygen corrosion. A color film layer 3 is provided on the side of the encapsulation layer group 4 away from the base substrate 10. The specific structures of the encapsulation layer and the color film layer 3 may refer to the silicon-based display panel shown in FIG. 1, and will not be described in detail here.

According to the embodiments of the present disclosure, there is further provided a display apparatus, which may include the display panel according to any one of the embodiments of the present disclosure. The specific structure and beneficial effects of the display panel have been described in detail above, so they will not be repeated here.

It should be noted that, in addition to the display panel, the display apparatus further includes other necessary components and components, such as a housing, a circuit board, a power line, etc. Those skilled in the art may make corresponding supplements according to the specific use requirements of the display apparatus, which will not be repeated here.

In a case that the display panel is in the structure shown in FIG. 1 to FIG. 16, the display apparatus may also be an emerging wearable device, such as a virtual reality device or an augmented reality device. In a case that the display panel is in the structure shown in FIG. 17, the display apparatus may be a traditional electronic device, such as a mobile phone, a computer, a television, and a camcorder, which is not listed one by one here.

After considering the description and practicing the invention disclosed here, those skilled in the art will easily come up with other embodiments of the present disclosure. The present application is intended to cover any modification, use or adaptation of the present disclosure, which follows the general principles of the present disclosure and includes common general knowledge or conventional technical means in the art that are not disclosed in the present disclosure. The description and examples are intended to be exemplary only, and the true scope and spirit of the present disclosure are indicated by the appended claims.

## Claims

1. A display panel, comprising:
a driving backplane;
a plurality of pixel electrodes, provided at intervals on a side of the driving backplane;
a pixel definition layer, provided on a side of the plurality of pixel electrodes away from the driving backplane, wherein the pixel definition layer is provided with pixel openings exposing the pixel electrodes, a pixel definition portion is provided between two adjacent pixel openings, a surface of the pixel definition portion away from the driving backplane is formed with a recessed region between two adjacent pixel electrodes, a bottom surface of the recessed region comprises a first smooth curved surface raised towards a direction away from the driving backplane, and a partition groove is provided on the bottom surface of the recessed region;
a light-emitting layer group, provided on a side of the pixel definition layer away from the driving backplane, wherein the light-emitting layer group is disconnected in the partition groove; and
a common electrode, provided on a side of the light-emitting layer group away from the driving backplane, wherein the common electrode is formed with a protruding portion going close to the driving backplane in an orthographic projection region of the partition groove, and a contour of the protruding portion is a curve.

2. The display panel according to claim 1, wherein the partition groove comprises a first groove section and a second groove section sequentially away from the driving backplane, an orthographic projection of the second groove section on the driving backplane is located within an orthographic projection of the first groove section on the driving backplane, and an area of the orthographic projection of the second groove section on the driving backplane is smaller than an area of the orthographic projection of the first groove section on the driving backplane.

3. The display panel according to claim 2, wherein a side surface of the first groove section comprises a second smooth curved surface that is recessed towards a direction close to the pixel openings.

4. The display panel according to claim 3, wherein a curvature of the second smooth curved surface is greater than a curvature of the first smooth curved surface.

5. The display panel according to claim 2, wherein a bottom surface of the first groove section comprises a third smooth curved surface that is recessed towards a direction close to the driving backplane.

6. The display panel according to claim 5, wherein a curvature of the first smooth curved surface is greater than a curvature of the third smooth curved surface.

7. The display panel according to claim 1, wherein an angle between the bottom surface of the recessed region and a first direction is smaller than an angle between a side surface of the recessed region and the first direction, the angle between the side surface of the recessed region and the first direction is smaller than an angle between a side wall of a pixel opening and the first direction, and the first direction is perpendicular to a thickness direction of the display panel.

8. The display panel according to claim 2, wherein a pixel electrode comprises a first pixel electrode layer and a second pixel electrode layer, the first pixel electrode layer is provided on a side of the driving backplane, the second pixel electrode layer comprises a first covering portion, the first covering portion covers a surface of the first pixel electrode layer away from the driving backplane and covers a side surface of the first pixel electrode layer, and a material of the second pixel electrode layer is indium tin oxide.

9. The display panel according to claim 8, wherein the second pixel electrode layer further comprises a second covering portion and a third covering portion, the second covering portion is connected to the first covering portion and extends towards a direction close to the driving backplane, the third covering portion is connected to the second covering portion, and the third covering portion is located between two adjacent first pixel electrode layers.

10. The display panel according to claim 9, wherein an angle between the first direction and a portion of the first covering portion in contact with a side surface of the first pixel electrode layer is smaller than an angle between the second covering portion and the first direction.

11. The display panel according to claim 9, wherein the two adjacent pixel electrodes are defined as a first pixel electrode and a second pixel electrode respectively, a size of a third covering portion of the first pixel electrode in the first direction is D2, a size of a third covering portion of the second pixel electrode in the first direction is D2', a width of a portion of the recessed region that is located on a same side of the partition groove as the first pixel electrode is D1, a width of a portion of the recessed region that is located on a same side of the partition groove as the second pixel electrode is D1', and (D2-D2')×(D1-D1')>0.

12. The display panel according to claim 9, wherein a size of the first groove section in a second direction is greater than a size of the second covering portion in the second direction, and the second direction is a thickness direction of the display panel.

13. The display panel according to claim 9, wherein an orthographic projection of the protruding portion on the driving backplane does not overlap with an orthographic projection of the pixel electrode on the driving backplane.

14. The display panel according to claim 13, wherein an edge of the third covering portion is closer to an edge of the pixel opening than an edge of the first groove section in a first direction, and the first direction is perpendicular to a thickness direction of the display panel.

15. The display panel according to claim 2, wherein a pixel definition portion is provided between two adjacent pixel openings, the pixel definition portion comprises a first sub-portion and a second sub-portion sequentially provided in the direction away from the driving backplane, the first groove section is a first through hole passing through the first sub-portion, and the second groove section is a second through hole passing through the second sub-portion.

16. The display panel according to claim 3, wherein the pixel definition portion further comprises a third sub-portion, the third sub-portion fills a gap between the two adjacent pixel electrodes and partially covers the two pixel electrodes.

17. The display panel according to claim 2, wherein a width of the first groove section increases gradually in the direction away from the driving backplane.

18. The display panel according to claim 2, wherein a width of the second groove section decreases gradually in the direction away from the driving backplane.

19. The display panel according to claim 18, wherein an increase amplitude in the width of the first groove section increases gradually in the direction away from the driving backplane, and a decrease amplitude in the width of the second groove section decreases gradually in the direction away from the driving backplane.

20. The display panel according to claim 2, wherein the orthographic projection of the second groove section on the driving backplane overlaps with the orthographic projection of the first groove section on the driving backplane.

21. The display panel according to claim 2, wherein a width of the partition groove decreases gradually in the direction away from the driving backplane.

22. The display panel according to claim 1, wherein the light-emitting layer group comprises a light-emitting layer sub-group, a common layer is provided between the light-emitting layer sub-group and the pixel electrodes, the common layer is disconnected between two adjacent partition grooves, and the light-emitting layer sub-group covers the common layer and a discontinuous position of the common layer.

23. The display panel according to claim 1, wherein the driving backplane comprises a plurality of thin film transistors, and the thin film transistors are silicon-based thin film transistors.

24. A display apparatus, comprising the display panel according to any one of claims 1 to 23.
